# EUROPEAN PATENT SPECIFICATION

(11) **EP 2 485 248 B1**
(45) Date of publication and mention of the grant of the patent: **18.03.2020**
(21) Application number: 10820725.9
(22) Date of filing: 01.10.2010
(51) Int. Cl.: C23C 16/44, C23C 16/24

(54) **FILM FORMING METHOD USING CATALYTIC CVD DEVICE**
FILMBILDUNGSVERFAHREN WOBEI EINE KATALYTISCHE CVD-VORRICHTUNG VERWENDET WIRD
PROCÉDÉ DE FORMATION DE FILMS EN UTILISANT UN DISPOSITIF CATALYTIQUE CVD

(30) Priority: 02.10.2009 JP 2009230598
(43) Date of publication of application: 08.08.2012
(73) Proprietor: Sanyo Electric Co., Ltd., Osaka 570-8677 (JP); ULVAC, Inc., Chigasaki-shi, Kanagawa 253-8543 (JP)
(72) Inventor: KAI, Motohide, Moriguchi City, Osaka 570-0083 (JP); OSONO, Shuji, Chiba 289-1226 (JP); OKAYAMA, Satohiro, Kanagawa 253-8543 (JP); OGATA, Hideyuki, Kanagawa 253-8543 (JP)
(74) Representative: Mewburn Ellis LLP
(86) International application number: PCT/JP2010/067286
(87) International publication number: WO 2011/040611

(56) References cited:
- WO-A1-2010/067424
- JP-A- 2003 303 780
- JP-A- 2005 302 822
- JP-A- 2008 140 945
- JP-A- 2008 140 945
- US-A1- 2003 164 225
- US-A1- 2005 268 852
- US-A1- 2007 209 677

## Description

### TECHNICAL FIELD

The present invention relates to using catalytic CVD equipment for forming a film on a substrate.

### BACKGROUND ART

As a method for forming a predetermined deposited film on a substrate at the time of manufacturing a variety of semiconductor devices such as solar cells, in general, a CVD technique (a Chemical Vapor Deposition technique) is conventionally known. As one kind of such CVD technique, in recent years, a catalytic CVD technique utilizing Catalytic Chemical Vapor Deposition has been discussed (Patent Document 1, for example).

In the catalytic CVD technique, a raw material gas to be supplied into a reaction chamber is decomposed by employing a catalytic wire that is made of heated tungsten, molybdenum or the like and then a deposited film is formed on a substrate that is held on a holder. The catalytic CVD technique is expected as a method for formation of film, by which a substrate surface or a deposited film surface is less adversely affected, since such plasma discharge in a plasma CVD technique is not utilized.

US2005/268852 discloses a vacuum film-forming apparatus comprising substrate stages; vacuum chamber-forming containers opposed to the stages; a means for moving the substrate between the stages; and gas-introduction means connected to every container, wherein one of the stage and the container is ascended or descended towards the other to bring the upper face of the stage and the opening of the container into contact with one another so that vacuum chambers can be formed and that a raw gas and/or a reactant gas can be introduced into each space of the chamber through each gas-introduction means to carry out either the adsorption or reaction step for allowing the raw gas to react with the reactant gas.

### PRIOR ART DOCUMENT(S)

### PATENT DOCUMENT

Patent Document 1: Japanese Unexamined Patent Application Publication No. 2005-327995

### SUMMARY OF THE INVENTION

However, in the conventional catalytic CVD equipment, a catalytic wire easily breaks, there is a need to frequently replace such a faulty catalytic wire with its replacement wire; and therefore, there has been a problem that manufacturability is degraded.

Accordingly, the present invention has been made to solve the above-described problem, and it is an object of the present invention to provide a method for formation of film which is capable of realizing extended serviceable life of a catalytic wire.

According to the present invention there is provided a method of forming a film on a substrate using a catalytic CVD equipment as specified in claim 1.

The method according to the the present invention is capable of maintaining a temperature of a catalytic wire at a predetermined temperature which is lower than a temperature when the film is formed, and is higher than room temperature at each of predetermined time intervals before and after the film is formed. Therefore, according to the present invention, shrinkage and expansion of the catalytic wire can be mitigated, thus making it possible to realize extended serviceable life of the catalytic wire.

The method according to the present invention may optionally be as specified in any one of claims 2 to 4.

### BRIEF DESCRIPTION OF THE DRAWINGS

[Fig. 1] Fig. 1 is a schematic diagram showing a configuration of a catalytic CVD equipment 100 according to an embodiment.
[Fig. 2] Fig. 2 is a view for explaining flow of formation of firm according to Example.

### BEST MODE FOR CARRYING OUT THE INVENTION

Hereinafter, a catalytic CVD equipment will be described with reference to the drawings. It is to be noted that, in the following description of drawings, the same or similar constituent elements are designated by the same or similar reference numerals.

However, it should be kept in mind that the drawings are schematic, and a rate of each dimension is different from actual one. Therefore, specific dimensions or the like should be determined in consideration of the following description. In addition, it is a matter of course that portions with their different dimensional interrelationships or rates are included in the drawings.

### [Relationship between Power Supply to Catalytic Wire and Serviceable Life of Catalytic Wire]

In the conventional catalytic CVD equipment, a catalytic wire easily breaks, there is a need to frequently replace such a faulty catalytic wire with its replacement wire; and therefore, there has been a problem that manufacturability is degraded.

Accordingly, the present inventors made their utmost efforts in study with respect to why the catalytic wire easily breaks. As a result, it was determined that there had been a problem in that power supply to the catalytic wire is stopped after the completion of formation of film and then power supply to the catalytic wire is started again at the time of start of formation of film.

Specifically, when power supply to the catalytic wire has been stopped after the completion of formation of film, a temperature of the catalytic wire lowers from a temperature when the film is formed (for example, 1,600 degrees Centigrade to 2,000 degrees Centigrade) to the order of room temperature within several seconds due to a small thermal capacity of the catalytic wire; and therefore, the catalytic wire rapidly shrinks. In addition, when power supply to the catalytic wire has been started, the temperature of the catalytic wire rises from the order of room temperature to the temperature when the film is formed within several seconds; and therefore, the catalytic wire rapidly expands. It was determined that such shrinkage and expansion are repeated every time stop and start of power supply is switched, thereby reducing serviceable life of the catalytic wire.

The present invention contrives control of power supply to a catalytic wire to thereby realize extended serviceable life of the catalytic wire. Hereinafter, a description will be furnished, focusing on control of power supply to the catalytic wire.

### [Configuration of Catalytic CVD equipment]

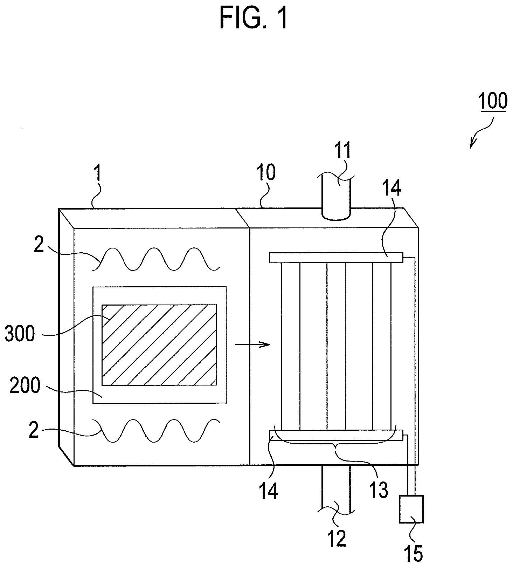

Hereinafter, a configuration of a catalytic CVD equipment according to the embodiment will be described with reference to the drawings. Fig. 1 is a schematic diagram showing a configuration of a catalytic CVD equipment 100.

As shown in Fig. 1, the catalytic CVD equipment 100 has a preparation chamber 1, a reaction chamber 10, and a takeout chamber (not shown). A substrate 300 that is held on a substrate tray 200 is moved from the preparation chamber 1 to the reaction chamber 10, making it possible to form a deposited film on the substrate 300.

It is to be noted that the preparation chamber 1, the reaction chamber 10, and the takeout chamber are evacuated at a pressure lower than about 1 x 10⁻⁴ Pa at a time other than when the film is formed in a normal operation state.

### (1) Configuration of Preparation Chamber

The preparation chamber 1 is a vacuum chamber for housing the substrate tray 200, and is constituted to enable evacuation in a vacuumed state. The preparation chamber 1 is provided with a heating mechanism 2 such as a lamp heater or a sheath heater.

The heating mechanism 2 heats the substrate 300 that is held on the substrate tray 200. In this manner, the moisture that is adsorbed on the substrate tray 200 and the substrate 300 is eliminated.

In addition, the preparation chamber 1 is provided with a take-in device and a takeout device, although not shown. The take-in device takes the substrate tray 200 in the preparation chamber 1. The takeout device takes out the substrate tray 200 that is ready for preparation in the preparation chamber 1 to the reaction chamber 10.

### (2) Configuration of Reaction Chamber

The reaction chamber 10 is a vacuum chamber for housing the substrate tray 200. The reaction chamber 10 is provided with a gas supply pipe 11, a gas discharge pipe 12, a plurality of catalytic wires 13, a mount portion 14, and a power source 15.

The gas supply pipe 11 is a flow path for supplying a raw material gas (such as a mixture gas of SiH₄ and H₂ or SiH₄, for example) into the reaction chamber 10.

The gas discharge pipe 12 is a flow path for discharging a raw material gas from the inside of the reaction chamber 10.

The catalytic wires 13 are heated to thereby decompose the raw material gas to be supplied into the reaction chamber 10. Both ends of the catalytic wires 13 are mounted to the mounted portion 14, and are disposed perpendicular to a bottom face of the reaction chamber 10. The catalytic wires 13 are heated to a temperature at which a raw material gas can be decomposed (hereinafter, referred to as a "decomposition temperature", which is 1,600 degrees Centigrade to 2,000 degrees Centigrade, for example), by means of power supply. The raw material gas is decomposed by means of the catalytic wires 13, and decomposed species reaches the substrate 300, whereby a deposited film (such as a semiconductor film or a SiN film, for example) is formed on the substrate 300.

The catalytic wires 13 can be made of a material such as Ta, Mo, or W-based wires. In addition, the catalytic wires 13 may have different kinds of layers on surface. According to the invention claimed in claim 1, the wire is a tantalum wire of which a borate layer is formed on surface. Further, the catalytic wires 11 with their diameter of 0.3 mm to 2.0 mm, preferably 0.5 mm to 1.0 mm are employed.

The power source 15 supplies power to the catalytic wires 13 via the mount portion 14. As the power source 15, there can be employed a constant current/constant voltage power supply that is capable of constant current power supply, constant voltage power supply or both of constant current power supply and constant power control.

In the embodiment, control of the power supply 15 may be either one of constant current control and constant power control, and a temperature of the catalytic wires 13 is controlled by setting a current value or a power value. That is, the current value or power value of the power source 15 is controlled so that a current flows into the catalytic wires 13 to an extent such that the temperature of the catalytic wires 13 is set at a predetermined temperature.

In addition, the reaction chamber 10 is provided with a take-in device and a takeout device, although not shown. In this manner, the substrate tray 200 is taken in the reaction chamber 10 or is taken out from the reaction chamber 10.

### (3) Configuration of Control Unit

The catalytic CVD equipment 100 has a control unit, although not shown.

The control unit always continuously supplies power to the catalytic wires 13 at the time of continuous operation of the catalytic CVD equipment 100.

Specifically, during a time period during which formation of film is to be performed on the substrate 300 in the reaction chamber 10 (hereinafter, referred to as "a time period when a film is formed"), the control unit power-supplies a current at which a temperature of the catalytic wires 13 can be heated to a decomposition temperature of a raw material gas. In addition, during a time period during which formation of film is not performed on the substrate 300 in the reaction chamber 10 (hereinafter, referred to as "a time period when no film is formed"), the control unit power-supplies a current at which the temperature of the catalytic wires 13 can be controlled to a temperature which is lower than the temperature of the catalytic wires 13 when the film is formed, and is higher than room temperature. In this way, power is continuously supplied to the catalytic wires 13 when the substrate tray 200 is not housed in the reaction chamber 10 as well. Therefore, the catalytic wires 13 are always powered from the time when the film is formed over the time when no film is formed.

In addition, it is defined in claim 1 that a temperature of the catalytic wires 13 when no film is formed (hereinafter, referred to as a "standby temperature") be a temperature which is lower than a temperature of the catalytic wires 13 when the film is formed, and be a temperature which is lower than a decomposition temperature of a raw material gas. In this manner, the catalytic wires 13 can be restrained from being always heated to a high temperature, thus making it possible to lessen expansion of the catalytic wires 13. As a result, extended serviceable life of the catalytic wires 13 can be realized.

Further, it is defined in claim 1 that a standby temperature be a temperature which is higher than a temperature when power supply to the catalytic wires 13 has been stopped (the order of room temperature), and be a temperature which is higher than a ductile-brittle transition temperature of the catalytic wires 13.

The "ductile-brittle transition" used herein denotes a phenomenon in which, in a case where a temperature of the catalytic wires has lowered, a material constituting the catalytic wires becomes significantly vulnerable due to the lowering of the temperature. In addition, the "ductile-brittle transition temperature" used herein denotes a temperature at which an ductile-brittle transition occurs with the catalytic wires or part of these wires. For example, the ductile-brittle transition temperature of tungsten (W), which is well known as a material for the catalytic wires, is 300 degrees Centigrade, and becomes extremely vulnerable if a temperature of less than 300 degrees Centigrade is reached. Therefore, in a case where W is employed for the catalytic wires, the standby temperature is set at a temperature which is higher than 300 degrees Centigrade that is the ductile-brittle transition temperature, thereby making it possible to realize extended serviceable life of the catalytic wires.

Although an ductile-brittle transition temperature in a case where the catalytic wires 13 have a laminate structure is not clear, for example, it is experimentally verified that, in catalytic wires employing tantalum having a tantalum borate layer on surface, a standby temperature is set at a temperature exceeding 500 degrees Centigrade to thereby realize extended serviceable life. Therefore, in the case of tantalum having a tantalum borate layer on surface, it is deemed that the ductile-brittle transition temperature is about 500 degrees Centigrade.

In addition, the temperature of the catalytic wires 13 when the film is formed can be appropriately selected as long as it is a temperature at which a raw material gas can be decomposed (i.e., a decomposition temperature), or alternatively, the temperature may be varied. Similarly, the standby temperature can be appropriately selected at a temperature which is lower than the temperature of the catalytic wires 13 when the film is formed, and is higher than room temperature, or alternatively, the temperature can be varied.

### [Method for Formation of Film Employing Catalytic CVD equipment]

Next, as one example of a method for formation of film employing the catalytic CVD equipment 100, a method for forming a semiconductor film will be described with reference to the drawings.

### (1) Preparation Chamber 1

First, the substrate 300 having a first main face and a second main face that is provided at an opposite side of the first main face is prepared. In the embodiment, the substrate 300 is made of a material such as glass.

Next, the substrate 300 is held on the substrate tray 200.

Next, the substrate tray 200 on which the substrate 300 is held is taken in the preparation chamber 1 that is maintained at an atmospheric pressure.

Next, by means of evacuation from a evacuation system, the inside of the preparation chamber 1 is evacuated at a predetermined pressure (1 x 10⁻⁴ Pa or less, for example), and by means of the heating mechanism 2, the substrate 300 and the substrate tray 200 are heated to the order of about 150 degrees Centigrade to 200 degrees Centigrade. In this manner, the moisture that is adsorbed to the substrate 300 and the substrate tray 200 is eliminated.

### (2) Formation of Amorphous Si film

Next, the substrate tray 200 on which the substrate 300 is held is taken from the preparation chamber 1, and is transferred into the reaction chamber 10. At this time, the catalytic wires 13 that are disposed in the reaction chamber 10 are preheated at a standby temperature by means of continuous power supply.

Next, a mixture gas of SiH₄ and H₂ is supplied as a raw material gas from the gas supply pipe 11 into the reaction chamber 10, and the pressure in the reaction chamber 10 is adjusted to a predetermined value (about 0.5 Pa to 10 Pa, for example).

Next, by increasing the current flowing in the catalytic wires 13, the catalytic wires 13 are heated up to a decomposition temperature of a raw material gas. In this manner, the raw material gas is decomposed by means of the catalytic wires 13, and decomposed species reaches the top of the first main face of the substrate 300. In this manner, an amorphous Si film is formed on the substrate 300.

Next, the current flowing in the catalytic wires 13 is reduced, and at the same time, supply of the raw material gas is stopped. In this manner, the catalytic wires 13 are heated up to a standby temperature by means of continuous power supply.

Next, after the pressure in the reaction chamber 10 has been set at about 1 x 10⁻⁴ or less by means of evacuation from the gas discharge pipe 12, the substrate tray 200 on which the substrate 300 is held is taken out to the takeout chamber and then is exposed in atmosphere.

While, in the embodiment, the current flowing in the catalytic wires 13 is reduced, and at the same time, supply of the raw material gas is stopped, the supply of the raw material gas may be stopped after the current has been reduced, or alternatively, the current may be reduced after the supply of the raw material gas has been stopped.

Next, a substrate tray 200 on which a newly prepared substrate 300 is held is taken from the preparation chamber 1 and then is transferred into the reaction chamber 10. At this time, the catalytic wires 13 are maintained at a standby temperature by means of continuous power supply.

Next, the abovementioned raw material gas is supplied from the gas supply pipe 11 into the reaction chamber 10, whereby the pressure in the reaction chamber 10 is adjusted to a predetermined value (about 0.5 Pa to 10 Pa, for example).

Next, by increasing the current flowing in the catalytic wire 13, the catalytic wires 13 are heated up to the decomposition temperature of the raw material gas. In this manner, the raw material gas is decomposed by means of the catalytic wires 13, and decomposed species reaches the top of the substrate 300.

As described above, in a case where formation of film on the substrate 300 is continuously performed, in the embodiment, the temperature of the catalytic wires 13 is controlled to a standby temperature which lower than the temperature of the catalytic wires 13 when the film is formed and is higher than room temperature before and after the film is formed on the substrate 300.

### [Functions and Advantageous Effects]

In the catalytic CVD equipment 100 according to the embodiment, the control unit controls a temperature of the catalytic wires 13 to a standby temperature during predetermined time periods before and after the film is formed. The standby time is a predetermined temperature which is lower than the temperature of the catalytic wires 13 when the film is formed, and is higher than room temperature.

Therefore, shrinkage and expansion that occur with the catalytic wires 13 can be mitigated in comparison with a case in which start and stop of power supply by means of the power source 15 is repeated. Thus, extended serviceable life of the catalytic wires 13 can be realized.

In addition, the standby temperature is lower than the temperature of the catalytic wires 13 when the film is formed. Therefore, the catalytic wires 13 are always maintained at a high temperature, whereby the catalytic wires can be restrained from being maintained in its expanded state.

Further, the catalytic wires 13 are not always set at a decomposition temperature, thus making it possible to restrain the substrate 300 from being overheated. As a result, the quality of film that is formed on the substrate 300 can be restrained from being degraded.

Furthermore, it is defined in claim 1 that the standby temperature be higher than the ductile-brittle transition temperature of the catalytic wires 13. In this case, the fact that the ductile-brittle transition temperature occurs with the catalytic wires 13 can be restrained, thus making it possible to realize extended serviceable life of the catalytic wires 13.

Still furthermore, it is preferable that the standby temperature be a temperature at which a temperature of the substrate 300 can be maintained to be lower than a temperature at which film quality of a film such as an amorphous semiconductor film or a finely crystalline semiconductor film formed on the substrate 300 varies. In this case, variation of the film quality can be restrained in the case where the film such as the amorphous semiconductor film or the finely crystalline semiconductor film has been formed on the substrate 300 as well.

Yet furthermore, power is continuously supplied to the catalytic wires 13 at predetermined time intervals before and after the film is formed, whereby the catalytic wires 13 can be controlled at a predetermined temperature without a need to employ another heating mechanism such as a heater. As a result, reduction of equipment costs can be realized.

Moreover, in the method for formation of film according to the embodiment, the abovementioned catalytic CVD equipment 100 is employed, thus making it possible to lessen replacement frequency of the catalytic wires 13. As a result, manufacturability of films can be improved.

### [Other Embodiments]

In the foregoing embodiment, for example, while a method for forming an amorphous Si film was described as one example of the method for formation of film to which the present invention is applied, the present invention is not limitative thereto. The present invention is also applicable to a method for forming a semiconductor film other than the amorphous Si film or a film other than a semiconductor film such as a SiN film. Further, the present invention is also applicable to a method for manufacturing semiconductor devices such as solar cells which are provided with at least one of a semiconductor film and films other than the semiconductor films.

In addition, while, in the foregoing embodiment, the catalytic CVD equipment 100 was arranged to be provided with only one reaction chamber 10, the present invention is not limitative thereto. The catalytic CVD equipment 100 may be provided with a plurality of reaction chambers. In this manner, films of a same kind or different kinds can be formed to be superimposed on the substrate 300. In a case where a film is further formed on a film that is formed on the substrate 300, it is preferable that the standby temperature be a temperature at which the temperature of the substrate 300 can be maintained to be lower than a temperature at which the quality of film that is formed on the substrate 300 varies. For example, in a case where an amorphous semiconductor film or a finely crystalline semiconductor film has been formed on the substrate 300, the standby temperature is controlled to a temperature at which the temperature of the substrate 300 can be maintained at about 300 degrees Centigrade or less, thereby making it possible to restrain variation of film quality due to elimination of hydrogen or the like.

### EXAMPLE

### [Example]

First, a tantalum wire whose surface had been borated was disposed as a catalytic wire in a reaction chamber.

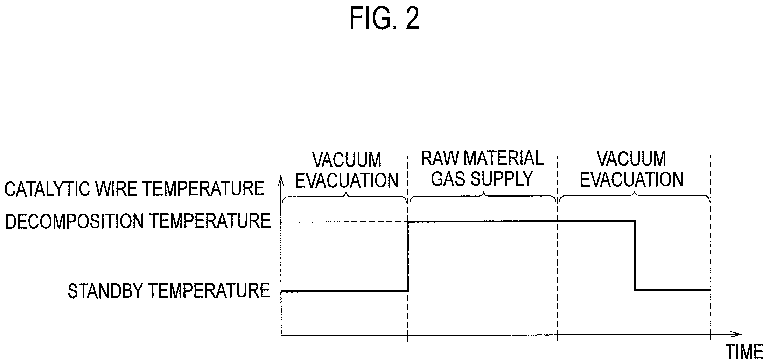

Next, heating and cooling of the catalytic wire were repeatedly performed in accordance with the flowchart shown in Fig. 2.

Specifically in the step of vacuum-evacuating the inside of the reaction chamber in advance, a temperature of the catalytic wire was first maintained at a standby temperature (500 degrees Centigrade to 700 degrees Centigrade).

Next, the temperature of the catalytic wire was maintained at a decomposition temperature (1,600 degrees Centigrade to 2,000 degrees Centigrade) from the step of supplying a raw material gas into the reaction chamber up to partway of the step of vacuum-evacuating the raw material gas from the inside of the reaction chamber.

Next, the temperature of the catalytic wire was maintained at the standby temperature by continuously supplying power to the catalytic wire from partway of the step of vacuum-evacuating the raw material gas.

Then, the above steps were repeatedly performed until the catalytic wire had broken.

### [Comparative Example]

In Comparative Example, no power was supplied to the catalytic wire from the step of vacuum-evacuating the inside of the reaction chamber in advance and partway of the step of vacuum-evacuating a raw material gas. Everything else was performed in the same manner as that in Example.

### [Result]

In Example, serviceable life of the catalytic wire could be increased to be twice or more in comparison with that in Comparative Example. A reason why such a result was obtained is that power was continuously supplied to the catalytic wire in Example, and expansion and shrinkage of the catalytic wire could be mitigated.

### INDUSTRIAL APPLICABILITY

As described above, a catalytic CVD equipment is useful in the field of manufacturing catalytic CVD equipments, since extended serviceable life of catalytic wires can be realized. In addition, a method for formation of film and a process for production of solar cell, are useful in the field of manufacturing solar cells, since manufacturability can be improved.

### DESCRIPTION OF REFERENCE NUMERALS

- 1: Preparation chamber
- 2: Heating mechanism
- 10: Reaction chamber
- 11: Gas supply pipe
- 12: Gas discharge pipe
- 13: Catalytic wire
- 14: Mount portion
- 15: Power source
- 100: Catalytic CVD equipment
- 200: Substrate tray
- 300: Substrate

## Claims

1. A method of forming a film on a substrate (300) using a catalytic CVD equipment (100), the catalytic CVD equipment (100) comprising:
a reaction chamber (10);
a catalytic wire (13) installed in the reaction chamber (10);
a power source (15) for supplying power to the catalytic wire (13) to heat the catalytic wire (13); and
a control unit for controlling a temperature of the catalytic wire (13) by controlling power-supply from the power source (15) to the catalytic wire (13),
wherein the method comprises:
supplying a raw material gas to the catalytic wire (13) in the reaction chamber (10);
with the control unit, performing a film formation control by controlling the power-supply from the power source (15) to the catalytic wire (13) so that the temperature of the catalytic wire (13) is maintained at a decomposition temperature of the raw material gas, at a time at which formation of the film is to be performed onto the substrate (300) in the reaction chamber (10) by depositing generated decomposed species on the substrate (300), and
with the control unit, continuously before and after the film formation control, performing a no film formation control for controlling the power-supply from the power source (15) to the catalytic wire (13) so that the temperature of the catalytic wire (13) is maintained at a standby temperature which is lower than the decomposition temperature of the raw material gas and higher than a ductile-brittle transition temperature of the catalytic wire (13),
**characterized in that**:
the catalytic wire (13) comprises tantalum having a tantalum borate layer on a surface thereof; and
the no film formation control is performed using 500 degrees Centigrade as the ductile-brittle temperature.

2. The method according to claim 1, wherein:
the method comprises performing the film formation control and the no film formation control using a value between 1,600 degrees Centigrade and 2,000 degrees Centigrade as the decomposition temperature.

3. The method according to claim 1 or 2, wherein:
in a case where a second film is formed on a first film formed on a substrate (300) in the reaction chamber (10), the method comprises performing the no film formation control so that the standby temperature is maintained at a temperature lower than a temperature at which the film quality of the first film formed on the substrate (300) varies.

4. The method according to claim 3, wherein:
the first film is an amorphous semiconductor film or a finely crystalline semiconductor film; and
when forming the second film, the method comprises performing the no film formation control so that a temperature of the substrate (300) is maintained at a temperature lower than 300 degrees Centigrade.

## Patentansprüche

1. Verfahren zum Bilden eines Films auf einem Substrat (300) unter Verwendung einer katalytischen CVD-Anlage (100), wobei die katalytische CVD-Anlage (100) Folgendes umfasst:
eine Reaktionskammer (10);
einen katalytischen Draht (13), der in der Reaktionskammer (10) installiert ist;
eine Leistungsquelle (15) zum Bereitstellen von Leistung an den katalytischen Draht (13), um den katalytischen Draht (13) zu erwärmen; und
eine Steuereinheit zum Steuern einer Temperatur des katalytischen Drahts (13) durch Steuern der Leistungsversorgung von der Leistungsquelle (15) an den katalytischen Draht (13),
wobei das Verfahren Folgendes umfasst:
Bereitstellen eines Rohmaterialgases an den katalytischen Draht (13) in der Reaktionskammer (10);
Durchführen einer Filmbildungssteuerung mit der Steuereinheit durch Steuerung der Leistungsversorgung von der Leistungsquelle (15) an den katalytischen Draht (13), sodass die Temperatur des katalytischen Drahts (13) auf einer Zersetzungstemperatur des Rohmaterialgases gehalten wird, zu einem Zeitpunkt, bei dem die Bildung des Films auf dem Substrat (300) in der Reaktionskammer (10) durchzuführen ist, indem erzeugte Zersetzungsprodukte auf dem Substrat (300) abgeschieden werden und
Durchführen einer Nicht-Filmbildungssteuerung mit der Steuereinheit, kontinuierlich vor und nach der Filmbildungssteuerung, zur Steuerung der Leistungsversorgung von der Leistungsquelle (15) an den katalytischen Draht (13), sodass die Temperatur des katalytischen Drahts (13) auf einer Standby-Temperatur gehalten wird, die niedriger als die Zersetzungstemperatur des Rohmaterialgases und höher als eine Sprödbruch-Übergangstemperatur des katalytischen Drahts (13) ist,
**dadurch gekennzeichnet, dass**:
der katalytische Draht (13) Tantal umfasst, das eine Tantalboratschicht auf seiner Oberfläche aufweist; und
die Nicht-Filmbildungssteuerung unter Verwendung von 500 °C als die Sprödbruch-Übergangstemperatur durchgeführt wird.

2. Verfahren nach Anspruch 1, wobei:
das Verfahren die Durchführung der Filmbildungssteuerung und der Nicht-Filmbildungssteuerung unter Verwendung eines Werts zwischen 1.600 °C und 2.000 °C als die Zersetzungstemperatur umfasst.

3. Verfahren nach Anspruch 1 oder 2, wobei:
in einem Fall, in dem ein zweiter Film auf einem ersten, auf einem Substrat (300) gebildeten Film in der Reaktionskammer (10) gebildet wird, das Verfahren das Durchführen der Nicht-Filmbildungssteuerung umfasst, sodass die Standby-Temperatur auf einer Temperatur gehalten wird, die niedriger als eine Temperatur ist, bei der die Filmqualität des ersten, auf dem Substrat (300) gebildeten Films variiert.

4. Verfahren nach Anspruch 3, wobei:
der erste Film ein amorpher Halbleiterfilm oder ein feinkristalliner Halbleiterfilm ist; und
das Verfahren beim Bilden des zweiten Films das Durchführen der Nicht-Filmbildungssteuerung umfasst, sodass eine Temperatur des Substrats (300) auf einer Temperatur gehalten wird, die niedriger als 300 °C ist.

## Revendications

1. Procédé de formation d'un film sur un substrat (300) utilisant un équipement CVD catalytique (100), l'équipement CVD catalytique (100) comprenant :
une chambre de réaction (10) ;
un fil catalytique (13) installé dans la chambre de réaction (10) ;
une source d'électricité (15) pour fournir de l'électricité au fil catalytique (13) pour chauffer le fil catalytique (13) ; et
une unité de commande pour réguler une température du fil catalytique (13) par régulation de l'alimentation électrique de la source d'électricité (15) au fil catalytique (13),
le procédé comprenant :
la distribution d'un gaz de matière première vers le fil catalytique (13) dans la chambre de réaction (10) ;
avec l'unité de commande, la conduite d'une commande de formation de film par régulation de l'alimentation électrique de la source d'électricité (15) au fil catalytique (13) de sorte que la température du fil catalytique (13) soit maintenue à une température de décomposition du gaz de matière première, à un temps auquel la formation du film doit être effectuée sur le substrat (300) dans la chambre de réaction (10) par dépôt d'espèces décomposées générées sur le substrat (300), et
avec l'unité de commande, en continu avant et après la commande de formation de film, la conduite d'une commande de non-formation de film pour commander l'alimentation électrique de la source d'électricité (15) au fil catalytique (13) de sorte que la température du fil catalytique (13) soit maintenue à une température d'attente qui est inférieure à la température de décomposition du gaz de matière première supérieure à une température de transition ductile-fragile du fil catalytique (13),
**caractérisé en ce que** :
le fil catalytique (13) comprend du tantale comportant une couche de borate de tantale sur une surface de celui-ci ; et
la commande de non-formation de film est conduite en utilisant 500 degrés centigrade en tant que température de transition ductile-fragile.

2. Procédé selon la revendication 1, dans lequel :
le procédé comprend la conduite de la commande de formation de film et de la commande de non-formation de film en utilisant une valeur comprise entre 1 600 degrés centigrade et 2 000 degrés centigrade en tant que température de décomposition.

3. Procédé selon la revendication 1 ou 2, dans lequel :
dans un cas où un deuxième film est formé sur un premier film formé sur un substrat (300) dans la chambre de réaction (10), le procédé comprend la conduite de la commande de non-formation de film de sorte que la température d'attente soit maintenue à une température inférieure à une température à laquelle la qualité de film du premier film formé sur le substrat (300) varie.

4. Procédé selon la revendication 3, dans lequel :
le premier film est un film semi-conducteur amorphe ou un film semi-conducteur finement cristallin ; et
lors de la formation du deuxième film, le procédé comprend la conduite de la commande de non-formation de film de sorte qu'une température du substrat (300) soit maintenue à une température inférieure à 300 degrés centigrade.
